# EUROPÄISCHE PATENTSCHRIFT

(11) **EP 0 927 458 B1**
(45) Veröffentlichungstag und Bekanntmachung des Hinweises auf die Patenterteilung: **19.12.2001**
(21) Anmeldenummer: 97944715.8
(22) Anmeldetag: 16.09.1997
(51) Int. Cl.: H03H 9/64, H03H 9/145

(54) **OBERFLÄCHENWELLENFILTER FÜR UNSYMMETRISCHE/SYMMETRISCHE UND SYMMETRISCHE/SYMMETRISCHE BETRIEBSWEISE**
SURFACE WAVE FILTER FOR ASYMMETRICAL/SYMMETRICAL AND SYMMETRICAL/SYMMETRICAL OPERATING MODE
FILTRE A ONDES DE SURFACE POUR MODE DE FONCTIONNEMENT ASYMETRIQUE/SYMETRIQUE ET SYMETRIQUE/SYMETRIQUE

(30) Priorität: 19.09.1996 DE 19638370
(43) Veröffentlichungstag der Anmeldung: 07.07.1999
(73) Patentinhaber: EPCOS AG, 81541 München (DE)
(72) Erfinder: STRAUSS, Georg, D-81667 München (DE); BAUREGGER, Josef, D-81737 München (DE)
(74) Vertreter: Epping, Wilhelm, Dipl.-Ing.
(86) Internationale Anmeldenummer: DE9702076
(87) Internationale Veröffentlichungsnummer: WO9812809

(56) Entgegenhaltungen:
- EP-A- 0 605 884
- DE-A- 2 846 510
- FR-A- 2 682 833
- US-A- 3 872 410

## Beschreibung

Die Erfindung betrifft ein im folgenden kurz OFW genanntes Oberflächenwellenfilter gemäß Oberbegriff des Anspruchs 1, das insbesondere für HF-Anwendungen einsetzbar ist.

In Kommunikationssystemen werden Signale unsymmetrisch oder symmetrisch verarbeitet, wobei in der Signalführung häufig zwischen beiden Betriebsarten gewechselt wird und so Bedarf an Filtern entsteht, die betrachtet ein-/ausgangsseitig unsymmetrisch/symmetrisch oder symmetrisch/symmetrisch betreibbar sind. Bestimmte Schaltungskonzepte erfordern zudem Filter mit vorstehend aufgezeigten Eigenschaften und zusätzlich unterschiedlichen Ein- und Ausgangsimpedanzen.

Im Handel befinden sich insbesondere für den Einsatz im HF-Bereich bestimmte unsymmetrisch/unsymmetrisch betreibbare OFW-Filter. Der Wechsel von unsymmetrischer zu symmetrischer Betriebsart erfolgt bislang üblicherweise mittels zusätzlicher Bauteile, z.B. Übertrager. Die Impedanzen, d.h. die Ein- und Ausgangsimpedanzen dieser Filter sind gleich und werden durch Netzwerke, bestehend aus Induktivitäten und Kapazitäten, angepaßt.

Auch sind unsymmetrisch/symmetrisch oder symmetrisch/symmetrisch betreibbare OFW-Filter bekannt. Das Prinzip eines solchen Filters, d.h. in vorliegendem Fall eines Einspurfilters mit gleichen Ein- und Ausgangsimpedanzen, zeigt in schematischer Darstellung Figur 1, die beispielsweise aus der EP 0 605 885 A1 bekannt ist.

Die Struktur dieses OFW-Filters besteht aus einem mittig angeordneten interdigitalen Eingangswandler IDT 3, aus den in sich kurzgeschlossenen Reflektoren REF1 und REF 5 und parallel geschalteten interdigitalen Ausgangswandlern IDT 2 und IDT 4.

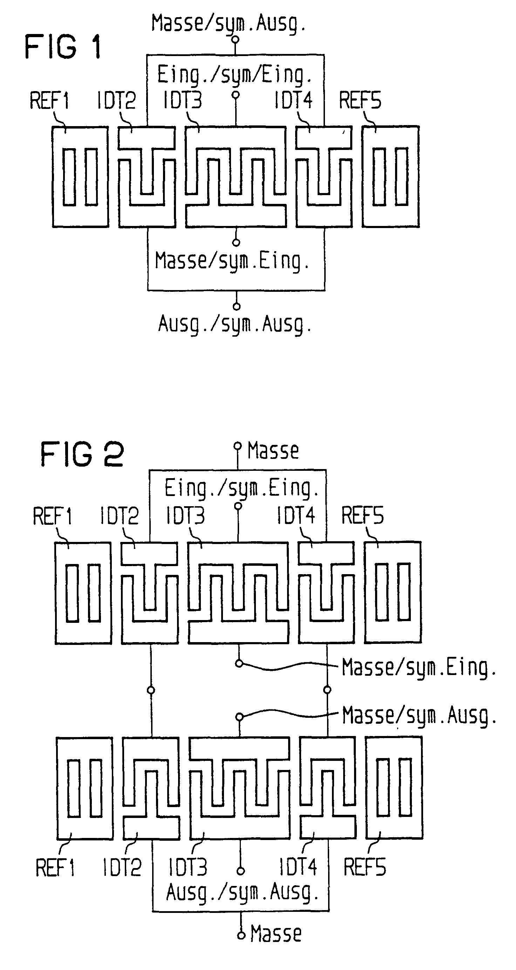

Soll die Filter-Selektion erhöht werden, so kann, wie dies Fig. 2 wiederum schematisch zeigt - gleiche Elemente sind dabei mit gleichen Bezugszeichen bezeichnet -, das bekannte Einspurfilter nach Fig. 1 z.B. mit einem Filter des gleichen Typs in Reihe geschaltet werden. Auch dieses Filter besitzt gleiche Ein- und Ausgangsimpedanzen und ist unsymmetrisch/symmetrisch oder symmetrisch/symmetrisch betreibbar.

Eine solche auch als Kaskadierung bezeichnete Reihenverschaltung mehrerer Filterspuren ist aus der bereits genannten EP 0 605 884 A1 bekannt.

Der vorliegenden Erfindung liegt, wie bereits eingangs erwähnt ist, die Aufgabe zugrunde, OFW-Filter zu schaffen, die gleichfalls unsymmetrisch/symmetrisch, symmetrisch/ symmetrisch oder unsymmetrisch/unsymmetrisch betreibbar sind, jedoch unterschiedliche Ein- und Ausgangsimpedanzen besitzen.

Zur Lösung dieser Aufgabe sieht die Erfindung bei einem OFW-Filter gemäß Oberbegriff des Anspruchs 1 vor, daß es mit einem weiteren, aus einem Grundglied bestehenden Oberflächenwellenfilter in Reihe geschaltet ist, wobei ein Grundglied in Reihe geschaltete Oberflächenwellen Eintorresonatoren und hierzu parallel geschaltete Oberflächenwellen-Eintoresonatoren umfaßt.

Durch die gespiegelte Anordnung der Ausgangswandler können ihre Anschlüsse auf eine Seite der Filterstruktur gelegt und damit die entsprechenden Kontaktbahnen kurz gehalten werden.

Dies trägt zu einer platzsparenden Filterstruktur bei und mindert gegebenenfalls störende induktive und kapazitive Einflüsse.

Schaltet man nun das OFW-Filter mit einem OFW-Filter in Reihe, das aus einem Grundglied besteht, mit in Reihe und hierzu parallel geschalteten OFW-Eintorresonatoren, so erhält ein unsymmetrisch/symmetrisch oder symmetrisch/symmetrisch betreibbares Filter mit unterschiedlichen Ein- und Ausgangsimpedanzen, das die hohe Fernabselektion der Einspurfilterstruktur mit der hohen Nahselektion und der geringen Einfügedämpfung der verschalteten Eintorresonatoren vereint.

Unabhängig von obigem OFW-Filter wird gemäß einem weiteren Vorschlag nach der Erfindung allein durch gegebenenfalls kaskadierte Verschaltung des obigen Grundgliedes ein unsymmetrisch/symmetrisch, symmetrisch/symmetrisch oder unsymmetrisch/unsymmetrisch betreibbares Filter mit gleicher Ein- und Ausgangsimpedanz geschaffen, das hohe Nahselektion mit geringer, jedoch mit steigender Anzahl von kaskadierten Grundgliedern steigender Einfügedämpfung vereint.

Weitere Merkmale der Erfindung sind den restlichen Unteransprüchen, der Beschreibung und Zeichnung entnehmbar.

### Es zeigt jeweils in schematischer Darstellung:

- Figur 3 bis 5: ein erstes, zweites und drittes Ausführungsbeispiel eines OFW-Filters nach der Erfindung;
- Figur 6: einen an sich bekannten OFW-Eintorresonator;
- Figur 7: ein Schaltbild eines weiteren Ausführungsbeispieles eines OFW-Filters nach der Erfindung;
- Figur 8: die Übertragungsfunktion des OFW-Filters nach Figur 7;
- Figur 9: bis 11 weitere Ausführungsbeispiele des OFW-Filters nach Figuren 5 und 7.

In den Figuren sind in Übereinstimmung mit den Bezeichnungen in Figuren 1 und 2 jeweils gleiche Elemente mit gleichen Bezugszeichen versehen.

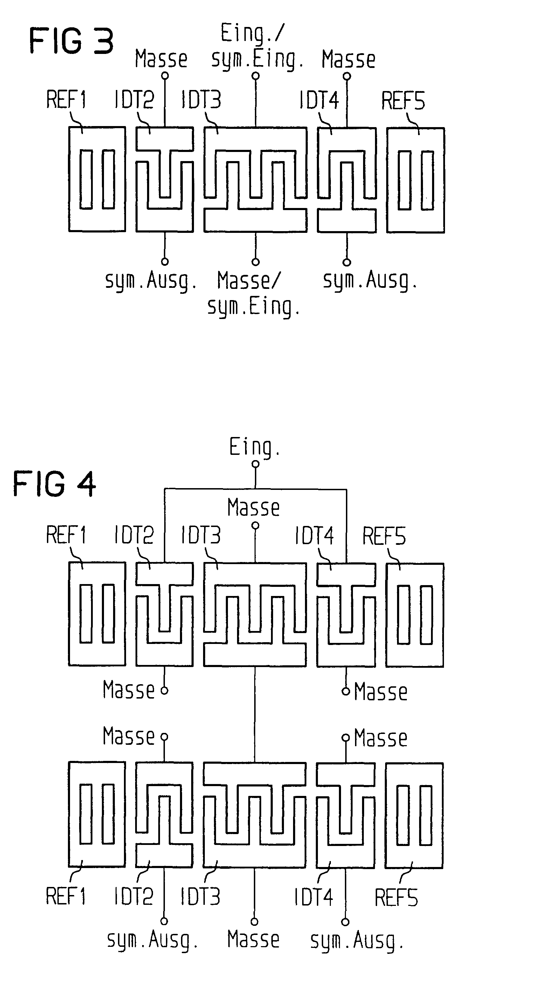

Figur 3 zeigt eine auf ein nicht dargestelltes an sich bekanntes piezoelektrisches Substrat aufgebrachte Struktur eines OFW-Einspurfilters mit interdigitalem Eingangswandler IDT 3, in Reihe geschalteten interdigitalen Ausgangswandlern IDT 2 und IDT 4 und Reflektoren REF 1 und REF 5. Durch Spiegelung der Ausgangswandler zueinander um die Ausbreitungsrichtung der Oberflächenwellen sind deren getrennte Ausgänge auf einer Seite der Filterstruktur angeordnet. Hierdurch entfallen lange Anschlußkontaktbahnen, was eventuell störende induktive und/oder kapazitive Einflüsse mindert und zusätzlich zu einer Platzersparnis führt.

Durch die Reihenschaltung der beiden Ausgangswandler IDT 2 und IDT 4 wird, wie angestrebt, die Impedanz ausgangsseitig erhöht und beträgt z.B. 150 Ω bei 50 Ω Eingangsimpedanz. Wie darüberhinaus gefordert ist, ist das Filter zudem unsymmetrisch/symmetrisch oder symmetrisch/symmetrisch betreibbar.

Ein OFW-Zweispurfilter mit gleichfalls unterschiedlicher Ein- und Ausgangsimpedanz, das in obiger Weise betreibbar ist, zeigt Figur 4, wobei das mit seinen Ausgangswandlern seriell geschaltete Einspurfilter nach Figur 3 zur Erhöhung der Selektion des Filters mit mindestens einem Einspurfilter mit parallel geschalteten interdigitalen Ausgangswandlern (s. Figuren 1 und 2) in Reihe geschaltet ist.

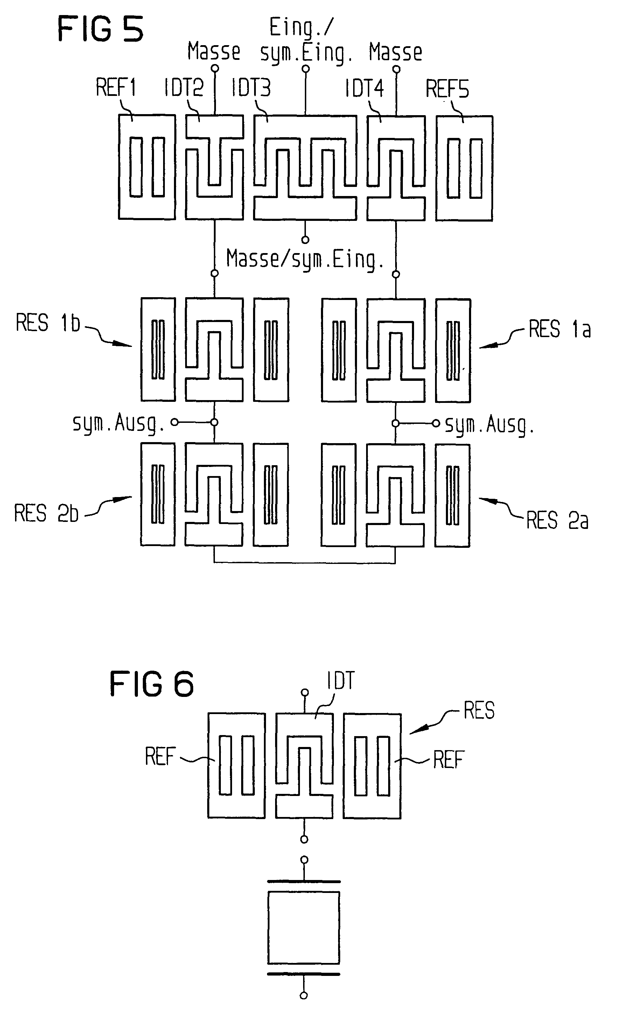

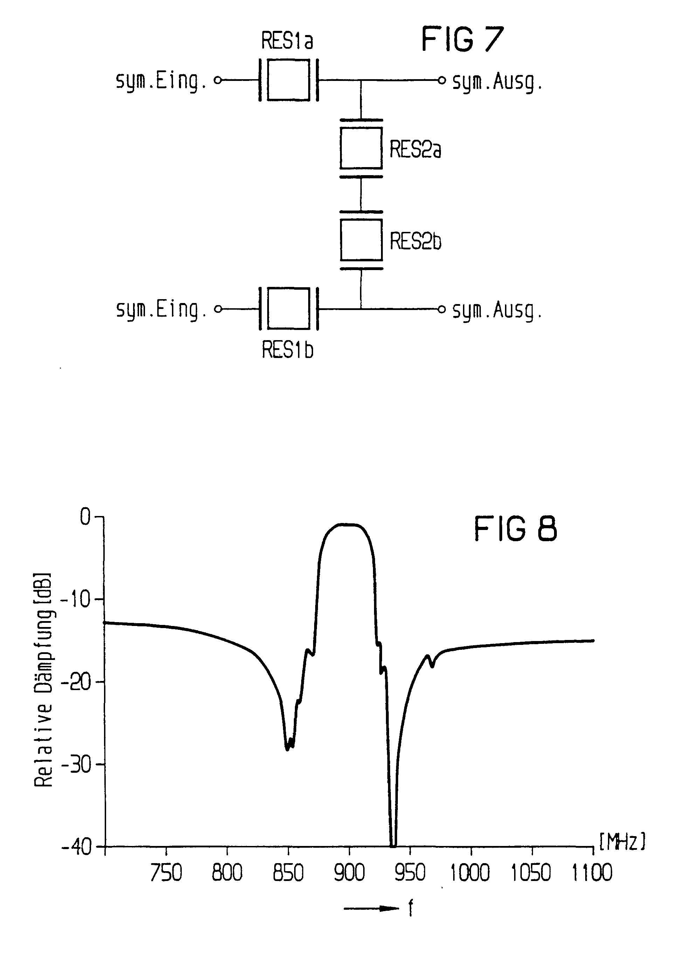

Beim Ausführungsbeispiel nach Figur 5 ist das OFW-Einspurfilter nach Figur 3 mit einem OFW-Filter in Reihe geschaltet, das aus einem z.B. in Figur 7 getrennt dargestellten und u. a. symmetrisch/symmetrisch betreibbaren Grundglied besteht mit in Reihe und hierzu parallel geschalteten OFW-Eintorresonatoren RES 1a, RES 1b bzw. RES 2a, RES 2b - s. hierzu auch den Eintorresonator RES nach Figur 6 mit Interdigitalwandler IDT und Reflektoren REF samt zugehörigem Schaltbild.

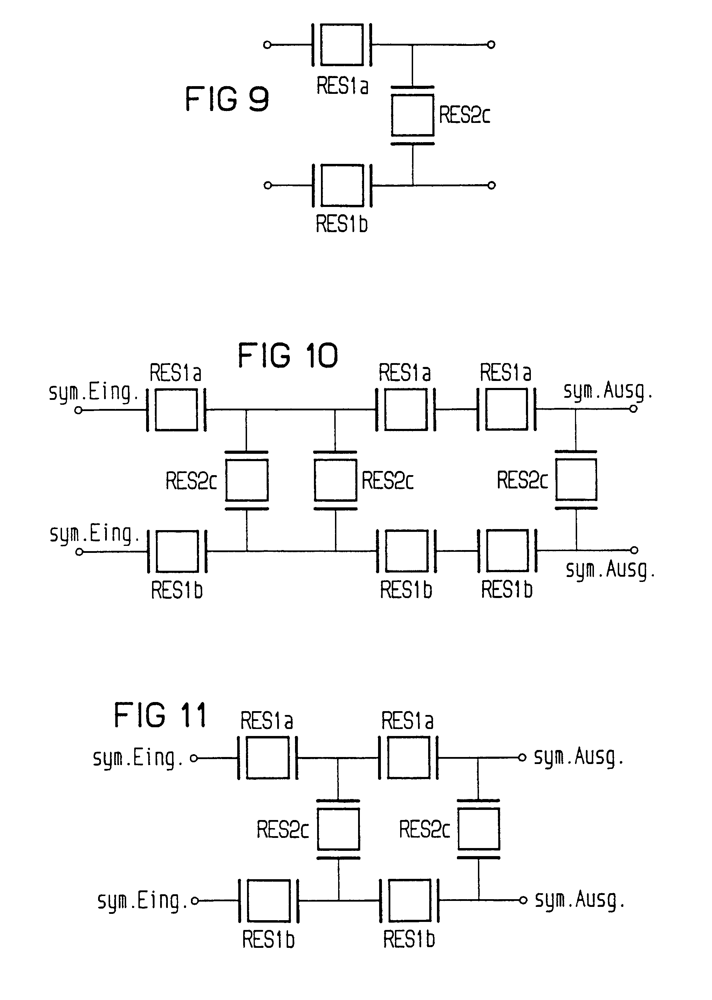

Dieses Filter erfüllt ebenfalls sämtliche Forderungen gemäß Aufgabe. Es zeichnet sich zudem dadurch aus, daß es die hohe Fernabselektion des OFW-Einspurfilters nach Figur 3 mit der hohen Nahselektion und der geringen Einfügedämpfung des Grundgliedes vereint. S. hierzu die Übertragungscharakteristik gemäß Figur 8 des Grundgliedes nach Figur 7.
Durch Anfügen weiterer Grundglieder, d.h. durch eine kaskadierte Verschaltung, wie sie Figur 10 zeigt, kann im übrigen die Fernabselektion bei steigender Einfügedämpfung erhöht werden.

Aus Gründen der Platzersparnis empfiehlt sich darüberhinaus, die parallel geschalteten Eintorresonatoren RES 2a und RES 2b jeweils durch einen einzelnen entsprechend dimensionierten Eintorresonator RES 2c zu ersetzen, wie dies in den Figuren 9 und 11 gezeigt ist.

Das beschriebene und gegebenenfalls kaskadiert verschaltete Grundglied ist im übrigen getrennt, d.h. an sich einsetzbar, wenn ein OFW-Filter gefordert wird, das z. B. nur symmetrisch/symmetrisch betreibbar sein soll. Durch entsprechende Wahl der seriell geschalteten Eintorresonatoren RES 1a, RES 1b und der hierzu parallel geschalteten Eintorresonatoren RES 2a, RES 2b ergibt sich die Übertragungscharakteristik eines Bandpaßfilters, wie es Figur 9 zeigt. Die Ein- und Ausgangsimpedanz dieses Filters ist gleich und wird durch einfache Modifikation, insbesondere der Apertur und Fingerzahl der interdigitalen Wandler individuell eingestellt.

## Patentansprüche

1. Oberflächenwellenfilter, insbesondere für HF-Anwendungen, das unsymmetrisch/symmetrisch oder symmetrisch/symmetrisch betreibbar ist,
das in Reihe geschaltete interdigitale Ausgangswandler (IDT 2, IDT 4 (Figur 3)) aufweist,
**dadurch gekennzeichnet,**
**daß** es mit einem weiteren, aus einem Grundglied bestehenden Oberflächenwellenfilter in Reihe geschaltet ist,
wobei ein Grundglied in Reihe geschaltete Oberflächenwellen Eintorresonatoren (RES 1a, RES 1b) und hierzu parallel geschaltete Oberflächenwellen-Eintorresonatoren (RES 2a, RES 2b (Figur 5)) umfaßt.

2. Oberflächenwellenfilter nach Anspruch 1,
mit interdigitalen Ausgangswandler (IDT 2, IDT 4), die um die Ausbreitungsrichtung der Oberflächenwellen zueinander gespiegelt sind.

3. Oberflächenwellenfilter nach Anspruch 1 oder 2,
mit mittig angeordnetem interdigitalen Eingangswandler (IDT 3) mit hierzu beiderseits angeordneten, in Reihe geschalteten interdigitalen Ausgangswandlern (IDT 2, IDT 4) und Reflektoren (REF 1, REF 5 (Figur 3)).

4. Oberflächenwellenfilter nach Anspruch 1,
das mit mindestens einem Einspurfilter mit parallel geschalteten interdigitalen Ausgangswandlern (IDT 2, IDT 4) in Reihe geschaltet ist (Figur 4).

5. Oberflächenwellenfilter nach Anspruch 1,
das mit mehreren Grundgliedern kaskadiert verschaltet ist (Figuren 10, 11).

## Claims

1. Surface acoustic wave filter, in particular for RF applications, which can be operated asymmetrically/symmetrically or symmetrically/ symmetrically, which has series-connected interdigital output transducers (IDT 2, IDT 4 (Figure 3)),
**characterized in that** it is connected in series with a further surface acoustic wave filter consisting of a base element,
wherein a base element comprises series-connected surface acoustic wave one-port resonators (RES 1a, RES 1b) and surface acoustic wave one-port resonators (RES 2a, RES 2b (Figure 5)) connected in parallel therewith.

2. Surface acoustic wave filter according to Claim 1, having interdigital output transducers (IDT 2, IDT 4) which are mirror images of one another with respect to the propagation direction of the surface acoustic waves.

3. Surface acoustic wave filter according to Claim 1 or 2, having a centrally arranged interdigital input transducer (IDT 3) with, arranged on both sides thereof, series-connected interdigital output transducers (IDT 2, IDT 4) and reflectors (REF 1, REF 5 (Figure 3)).

4. Surface acoustic wave filter according to Claim 1, which is connected in series with at least one single-path filter having parallel-connected interdigital output transducers (IDT 2, IDT 4).

5. Surface acoustic wave filter according to Claim 1, which is cascade-interconnected with a plurality of base elements (Figures 10, 11).

## Revendications

1. Flltre d'onde de surface, notamment pour des applications HF, qui peut fonctionner en mode dissymétrique/symétrique ou symétrique/symétrique,
qui comporte des transducteurs (IDT2, IDT4 (figure 3)) interdigités montés en série,
**caractérisé**
**en ce qu'**il est monté en série avec un autre filtre d'onde de surface constitué d'un élément de base,
un élément de base comportant des résonateurs (RES 1a, RES 1b) à une porte d'onde de surface montés en série et des résonateurs (RES 2a, RES2b (figure 5)) à une porte d'onde de surface montés en parallèle à ceux-ci.

2. Filtre d'onde de surface suivant la revendication 1,
comprenant des transducteurs (IDT 2, IDT 4) de sortie interdigités qui sont symétrique comme en un miroir par rapport à la direction de propagation des ondes de surface.

3. Filtre d'ondes de surface suivant la revendication 1 ou 2,
comprenant un transducteur (IDT 3) interdigité disposé au milieu et ayant des transducteurs (IDT 2, IDT 4) de sortie interdigités et des réflecteurs (REF1, REF 5 (figure 3)) disposés à cet effet des deux côtés et montés en série.

4. Filtre d'ondes de surface suivant la revendication 1,
qui est monté en série avec au moins un filtre à simple voie ayant des transducteurs (IDT 2, IDT 4) de sortie interdigités montés en parallèle (figure 4).

5. Filtre d'ondes de surface suivant la revendication 1,
qui est monté en cascade avec plusieurs éléments de base (figures 10, 11).
